# EUROPEAN PATENT SPECIFICATION

(11) **EP 3 306 359 B1**
(45) Date of publication and mention of the grant of the patent: **04.03.2020**
(21) Application number: 15893360.6
(22) Date of filing: 28.05.2015
(51) Int. Cl.: G02B 5/08, C08F 283/01, F21V 7/22, H01L 33/60, C08K 3/22, C08K 5/12, C08K 9/02, C08K 9/04, C08L 31/06, C08L 31/08

(54) **LIGHT-REFLECTING MATERIAL, LIGHT-REFLECTING BODY AND LIGHTING DEVICE**
LICHTREFLEKTIERENDES MATERIAL, LICHTREFLEKTIERENDER KÖRPER UND BELEUCHTUNGSVORRICHTUNG
MATÉRIAU RÉFLÉCHISSANT LA LUMIÈRE, CORPS RÉFLÉCHISSANT LA LUMIÈRE ET DISPOSITIF D'ÉCLAIRAGE

(43) Date of publication of application: 11.04.2018
(73) Proprietor: Otsuka Chemical Co., Ltd., Osaka-shi, Osaka 540-0021 (JP)
(72) Inventor: HARADA Kenji, Yokohama-shi Kanagawa 222-0033 (JP); TAKADA Takafumi, Yokohama-shi Kanagawa 222-0033 (JP); MIZUGUCHI Ayako, Yokohama-shi Kanagawa 222-0033 (JP)
(74) Representative: Vossius & Partner Patentanwälte Rechtsanwälte mbB
(86) International application number: PCT/JP2015/065385
(87) International publication number: WO 2016/189726

(56) References cited:
- EP-A1- 2 629 342
- WO-A1-2010/150880
- WO-A1-2013/183219
- JP-A- 2015 055 785
- JP-A- 2015 074 772
- DATABASE WPI Week 200431 Thomson Scientific, London, GB; AN 2004-333973 XP002786943, -& JP 2004 043563 A (DAISO CO LTD) 12 February 2004 (2004-02-12)

## Description

### [TECHNICAL FIELD]

The present invention relates to a light reflector material, a light reflecting body, and a lighting device

### [BACKGROUND ART]

An LED lighting device has come into wide use remarkably. The lighting device, however, had a drawback. The drawback is that the lighting device cannot keep its initial luminance for a long time. The degrading of luminance is caused by deterioration of reflectance resulting in discoloration of an LED reflector (light reflecting body). That is, for prolonging a life of LED lighting device, it is necessary to produce the LED reflector with a material hardly being discolored.

A ceramic-made LED reflector was proposed (Patent Literature 1).

A nylon (polyamide resin)-made reflector was proposed (Patent Literatures 2, 3, and 4).

A diallyl phthalate resin-made reflector was proposed (Patent Literature 5).

Patent Literature 5 proposes "A diallyl phthalate resin composition containing: diallyl phthalate prepolymer; polymerization initiator; titanium oxide; and light stabilizer; wherein titanium oxide is titanium oxide powder adjusted to 80-97 mass% as a titanium dioxide content and a content thereof in the composition is 5-120 pts.wt. to 100 pts.wt. of diallyl phthalate prepolymer."

An unsaturated polyester resin-made reflector was proposed (Patent Literatures 6, 7, and 8).

For example, Patent Literature 6 proposes "an unsaturated polyester resin composition for LED reflector: wherein the composition is a dry-type unsaturated polyester resin composition containing at least unsaturated polyester resin, polymerization initiator, inorganic filler, white pigment, mold release agent, and reinforcement; wherein a content of the unsaturated polyester resin to a total content of the composition is within a range of 14-40 mass%; wherein a total blending amount of the inorganic filler and the white pigment to the total amount of the composition is within a range of 44-74 mass%; wherein a ratio of the white pigment to a total blending amount of the inorganic filler and the white pigment is 30 mass% or more; and wherein the unsaturated polyester resin is a mixture of unsaturated alkyd resin and a crosslinking agent", "the unsaturated polyester resin composition for LED reflector: wherein the reinforcement is a glass fiber; and wherein a blending amount of the reinforcement is 10-100 pts.mass to 100 pts.mass of the unsaturated polyester resin", "an LED reflector formed of the unsaturated polyester resin composition for LED reflector", and "an LED lighting device with the LED reflector attached thereto".

Patent Literature 7 proposes "a surface-mounting light emitting device comprising: a light emitting element; a first resin body made of a dry-type unsaturated polyester resin molded body that has a recessed part and is integrally formed with a first lead for receiving the light emitting element and a second lead to be electrically connected to the light emitting element; and a second resin body for covering the light emitting element that is placed over the recessed part of the first resin body; wherein a bottom surface portion of the recessed part is provided with the first lead with the light emitting element, the first lead exposing from the bottom surface portion, and a resin insulated part provided between the first lead and the second lead; wherein the dry-type unsaturated polyester resin molded body is a dry-type unsaturated polyester resin composition containing at least unsaturated polyester resin, polymerization initiator, inorganic filler, white pigment, mold release agent, and reinforcement; wherein an amount of the unsaturated polyester resin to a total amount of the composition is within a range of 14 to 40 mass%; wherein a total blending amount of the inorganic filler and the white pigment to the total amount of the composition is within a range of 44 to 74 mass%; wherein a ratio of the white pigment to a total blending amount of the inorganic filler and the white pigment is 30 mass% or more; and wherein the unsaturated polyester resin is a mold of a dry-type unsaturated polyester resin composition that is a mixture of unsaturated alkyd resin and a crosslinking agent", and "the surface-mounting light emitting device: wherein the reinforcement is a glass fiber; and wherein a blending amount of the reinforcement is 10 to 100 pts.mass to 100 pts.mass of the unsaturated polyester resin".

Patent Literature 8 proposes "a molding material for light reflecting body comprising: unsaturated polyester resin; and a white pigment; wherein the unsaturated polyester resin contains crystalline unsaturated polyester having a melting point within a range of 65 to 100 °C, diallyl phthalate, isodiallyl phthalate, and a crosslinking component made of at least one compound selected from the group consisting of a polymer of at least one of the compound of diallyl phthalate and isodiallyl phthalate".

Patent Literature 9 proposes "a crystalline unsaturated polyester resin composition for LED reflector plate, comprising: at least crystalline unsaturated polyester resin and an inorganic filler; wherein the crystalline unsaturated polyester resin is composed of crystalline unsaturated polyester and copolymeric monomer and/or copolymeric polymer; and wherein the crystalline unsaturated polyester resin composition contains a white pigment".

Patent Literature 10 to Patent Literature 13 propose an LED reflector made of crystalline unsaturated polyester.

### [CITATION LIST]

### [PATENT LITERATURE]

[PATENT LITERATURE 1] WO2006/013899
[PATENT LITERATURE 2] JP 1994-200153 A
[PATENT LITERATURE 3] JP 2002-374007 A
[PATENT LITERATURE 4] JP 2010-100682 A
[PATENT LITERATURE 5] JP 2008-255338 A
[PATENT LITERATURE 6] JP4844699
[PATENT LITERATURE 7] JP4893874
[PATENT LITERATURE 8] JP 2015-55785 A
[PATENT LITERATURE 9] JP5153952
[PATENT LITERATURE 10] JP 2014-77071 A
[PATENT LITERATURE 11] JP 2014-19747 A
[PATENT LITERATURE 12] JP 2014-207304 A
[PATENT LITERATURE 13] JP 2013-251510 A

### [SUMMARRY OF INVENTION]

### [TECHNICAL PROBLEM]

The LED reflector of Patent Literature 1 had the following drawback. The ceramics is poor in processability. This increases manufacturing cost. Therefore, the ceramics is not suitable for an LED reflector for general use.

The LED reflectors of Patent Literatures 2, 3, and 4 had such a drawback that the LED reflector largely discolored by heat. This makes a lifetime of an LED lighting device short.

The LED reflector of Patent Literature 5 was poor in heat resistance. This makes a lifetime of an LED lighting device short.

The LED reflectors of Patent Literatures 6 and 7 were poor in heat resistance. This makes a lifetime of an LED lighting device short.

Patent Literature 8 (paragraph [0031]) discloses that preferable unsaturated polyester in a molding material contains only crystalline unsaturated polyester. There is a description stating that the unsaturated polyester in a molding material may contain uncrystallized unsaturated polyester. It is, however, disclosed that a preferable ratio of the crystalline unsaturated polyester to a total amount of crystalline unsaturated polyester and uncrystallized unsaturated polyester is 40 mass% or more. Patent Literature 8 discloses that, from the perspective of formability, use of crystalline unsaturated polyester is preferred.

Patent Literature 8 discloses "uncrystallized unsaturated polyester: produced by JAPAN U-PICA Company. Ltd., product name: U-PICA 8552L, melting point: 80°C". The uncrystallized resin has a glass transition temperature (softening temperature) but does not have a melting point (Mp).

Patent Literature 9 gave several drawbacks in a case where the uncrystallized polyester resin is used (paragraphs [0010] to [0015]). More specifically, Patent Literature 9 shows that a material using "uncrystallized unsaturated polyester" is not preferred to be used in an LED reflector. Patent Literature 9 discloses that crystalline polyester resin is to be used in an LED reflector.

Patent Literature 10 also discloses "uncrystallized unsaturated polyester: produced by JAPAN U-PICA Company. Ltd., product name: U-PICA 8552". Patent Literature 10 is directed to an invention basically using crystalline unsaturated polyester. Patent Literature 10 exemplified uncrystallized unsaturated polyester as a comparison example. Examples10 and 11 where uncrystallized unsaturated polyester was used were given a comprehensive evaluation of Δ, and Comparison Examples 2 and 3 where uncrystallized unsaturated polyester was used were given a comprehensive evaluation of ×. More specifically, Patent Literature 10 shows that a material using "uncrystallized unsaturated polyester" is not suitable to be used in an LED reflector.

Patent Literature 11 also discloses "uncrystallized unsaturated polyester: produced by JAPAN U-PICA Company. Ltd., product name: U-PICA 8552". Patent Literature 11, however, exemplified uncrystallized unsaturated polyester as a comparison example. Comparison Examples 1 and 2 where uncrystallized unsaturated polyester was used were given a comprehensive evaluation of ×. More specifically, Patent Literature 11 shows that a material using "uncrystallized unsaturated polyester" is not suitable to be used in an LED reflector. Further, Patent Literature 11 lists drawbacks of a material using "uncrystallized unsaturated polyester" (paragraphs [0014] to [0018]).

Patent Literature 12 also discloses "uncrystallized unsaturated polyester: produced by JAPAN U-PICA Company. Ltd., product name: U-PICA 8552". Patent Literature 12, however, exemplified uncrystallized unsaturated polyester as a comparison example. Comparison Examples 3 and 4 where uncrystallized unsaturated polyester is used shows poor formability. More specifically, Patent Literature 12 shows that a material using "uncrystallized unsaturated polyester" is not suitable to be used in an LED reflector. Further, Patent Literature 12 also lists drawbacks of a material using "uncrystallized unsaturated polyester".

Patent Literature 13 also discloses "uncrystallized unsaturated polyester: produced by JAPAN U-PICA Company. Ltd., product name: U-PICA 8552". Patent Literature 13 is directed to an invention basically using crystalline unsaturated polyester. Patent Literature 13 exemplified uncrystallized unsaturated polyester as a comparison example. Comparison Example 1 where uncrystallized unsaturated polyester is used is given a comprehensive evaluation of ×. More specifically, Patent Literature 13 shows that a material using "uncrystallized unsaturated polyester" is not suitable to be used in an LED reflector. Further, Patent Literature 13 also lists drawbacks of a material using "uncrystallized unsaturated polyester" (paragraphs [0010] to [0015]).

Crystalline resin is generally excellent in fatigue resistance and mechanical strength. Crystalline resin has a high reinforced effect owing to a filler. Crystalline resin is excellent in chemical resistance. In view of the above points, it is easy to understand the reason why the Patent Literatures selected not uncrystallized unsaturated polyester but crystalline unsaturated polyester.

The LED reflectors using crystalline unsaturated polyester of the Patent Literatures, however, could not show satisfactory results.

Thermosetting epoxy resin shows a good heat resistance (less discoloration by heat). Based on this point, a thermosetting epoxy resin-made LED reflector was studied. Epoxy resin has a good adhesive strength with a lead frame. More specifically, epoxy resin has a large adhesive strength of burr (flash) generated upon molding to a frame. This means, reversely, there is a difficulty in removing burr. An epoxy resin material needs to be reserved at low temperature. This renders a difficulty in treatment thereof. Epoxy resin is relatively expensive. Epoxy resin has a difficulty in injection molding. Therefore, epoxy resin is not suitable to be used as an LED reflector constituent material.

The present invention was made to solve the above described problems. More specifically, a purpose of the present invention is to provide a light reflector material having less warp or sink, high dimensional accuracy, excellent heat resistance, excellent light resistance, excellent weather resistance (having little discoloration by heat and/or light), excellent impact resistance, and excellent processability.

### [SOLUTION TO PROBLEM]

Study for solving the above described problems has been keenly conducted. As a result, the inventors reach such an idea that a better way to solve some of the problems may be given by the use of uncrystallized unsaturated polyester than by the use of crystalline unsaturated polyester that has been proposed in this business field.

It would, however, be predictable from the disclosures of Patent Literatures 8 to 13, a way to the adoption of uncrystallized unsaturated polyester was not easy. For example, uncrystallized resin is basically rich in transparency. Therefore, it was doubtful if a light reflector material made of such material is really useful.

That said, some merits could be expected for the adoption of uncrystallized unsaturated polyester. How to use uncrystallized unsaturated polyester effectively has been continuously studied.

Then, after repeated trial and error, the inventors have reached the present invention.

The present invention proposes
a light reflector material:
wherein the material comprises at least thermosetting resin and a white-based pigment wherein the white-based pigment is at least one selected from the group consisting of titanium oxide, barium titanate, strontium titanate, aluminum oxide, magnesium oxide, zinc oxide, barium sulfate, magnesium carbonate, barium carbonate, and zirconium oxide; wherein an amount of the white-based pigment is 80-500 pts. mass to 100 pts.mass of the thermosetting resin;
wherein the thermosetting resin is made (is comprised; is composed) by using at least uncrystallized unsaturated polyester resin and diallyl phthalate and/or diallyl isophthalate; and
wherein 50/50 (mass ratio) ≤ (the diallyl phthalate and/or diallyl isophthalate)/(the uncrystallized unsaturated polyester resin) is satisfied.

The present invention proposes the light reflector material, wherein, preferably, (the diallyl phthalate and/or diallyl isophthalate)/(the uncrystallized unsaturated polyester resin) ≤ 80/20 (mass ratio) is satisfied.

The present invention proposes the light reflector material, wherein, preferably, 60/40 (mass ratio) ≤ (the diallyl phthalate and/or diallyl isophthalate)/(the uncrystallized unsaturated polyester resin) ≤ 70/30 (mass ratio) is satisfied.

The present invention proposes the light reflector material, wherein 0 ≤ (crystalline unsaturated polyester resin/uncrystallized unsaturated polyester resin) ≤ 1/3 (mass ratio) is satisfied.

The present invention proposes the light reflector material, wherein, preferably, the white-based pigment is titanium oxide-based powder.

The present invention proposes the light reflector material, wherein, preferably, the white-based pigment is treated with inorganic powder.

The present invention proposes the light reflector material, wherein, preferably, the inorganic powder is one or two or more selected from the group comprising (including) silica, alumina, and zirconia.

The present invention proposes the light reflector material, wherein, preferably, the white-based pigment is treated with an organic compound(substance).

The present invention proposes the light reflector material, wherein, preferably, the thermosetting resin is made (is comprised; is composed) by using a polymerization initiator.

The present invention proposes the light reflector material, wherein, preferably, an amount of the polymerization initiator is 1-10 pts.mass to 100 pts.mass of the thermosetting resin.

The present invention proposes the light reflector material, wherein, preferably, the material comprises (contains) an inorganic filler.

The present invention proposes the light reflector material, wherein, preferably, an amount of the inorganic filler is 80-500 pts.mass to 100 pts.mass of the thermosetting resin.

The present invention proposes the light reflector material, wherein, preferably, the inorganic filler is one or two or more selected from the group comprising (including) silica, aluminium hydroxide, aluminum oxide, magnesium oxide, barium sulfate, magnesium carbonate, and barium carbonate.

The present invention proposes the light reflector material, wherein, preferably, the material comprises (contains/includes) a mold release agent.

The present invention proposes the light reflector material, wherein, preferably, an amount of the mold release agent is 0.25-3.75 pts.mass to 100 pts.mass of the thermosetting resin.

The present invention proposes the light reflector material, wherein, preferably, the material comprises (contains/includes) a reinforcement.

The present invention proposes the light reflector material, wherein, preferably, an amount of the reinforcement is 75 pts.mass or less to 100 pts.mass of the thermosetting resin.

The present invention proposes the light reflector material, wherein, preferably, the material comprises (contains/includes) a silane coupling agent.

The present invention proposes the light reflector material, wherein, preferably, an amount of the silane coupling agent is 0.25-12.5 pts.mass to 100 pts.mass of the thermosetting resin.

The present invention proposes a light reflecting body made of (composed of) the light reflector material.

The present invention proposes a lighting device with a light reflecting body made of (composed of) the light reflector material.

### [ADVANTAGEOUS EFFECT OF INVENTION]

The light reflector material (composition) of the present invention has little warp or sink and high dimensional accuracy. The light reflector material is excellent in heat resistance, light resistance, and weather resistance (has little discoloration caused by heat and/or light). The light reflector material is also excellent in impact resistance and processability.

### [BRIEF DESCRIPTION OF DRAWINGS]

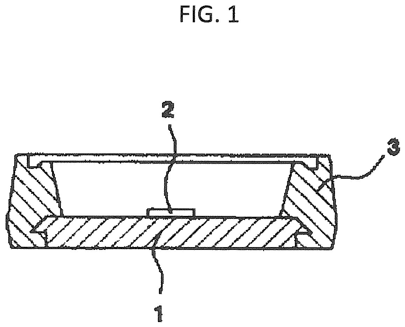

FIG. 1 is a schematic cross section view illustrating a lighting device (LED bulb).

### [Description of Examples]

Embodiments of the present invention will be described below.

The first invention is directed to a light reflector material. The reflection body comprises (includes) a reflector plate. The light reflector material is, for example, an LED reflector constituent material. The material comprises (includes/contains) at least thermosetting resin and a white-based pigment. The thermosetting resin is made (is comprised; is composed) by using at least uncrystallized unsaturated polyester resin and diallyl phthalate and/or diallyl isophthalate. (The thermosetting resin is made of at least uncrystallized unsaturated polyester resin and diallyl phthalate and/or diallyl isophthalate.) The thermosetting resin has such a structure that, for example, uncrystallized unsaturated polyester resin is crosslinked with a crosslinking agent (diallyl phthalate and/or diallyl isophthalate). The diallyl isophthalate is C₆H₄(COOCH₂CHCH₂)₂[1,3-Benzenedicarboxylic acid diallyl]. The diallyl phthalate is C₆H₄(COOCH₂CHCH₂)₂[1,2-Benzenedicarboxylic acid di-2-propenyl]. The diallyl isophthalate and the diallyl phthalate are divided into a monomer type, an oligomer type, and a mixture type thereof, respectively. An oligomer may be a mixture of two or more types. Any of the types is employable in the present invention. The oligomer means a compound that is dimerized, trimerized, ... by self-polymerization of monomer. The oligomer is divided into dimer, trimer, tetramer ... and so on. In the present invention, only the diallyl phthalate may be used. Alternatively, only the diallyl isophthalate may be used. Further alternatively, the both may be used. The unsaturated polyester resin is uncrystallized unsaturated polyester resin. The uncrystallized unsaturated polyester has a softening point temperature of, for example, 80°C to 110°C. A coefficient of linear expansion of a molded object becomes smaller as a content of white pigment, inorganic filler, or reinforcement becomes larger. If the coefficient of linear expansion is small, the molded object is hardly deformed. Even in an LED, heat generation is not avoidable. When the coefficient of linear expansion becomes larger in the molded object (LED reflector), a deformation degree becomes larger because of the heat generation of the LED. This is the problem to be solved. For solving the problem, an amount of white pigment, inorganic filler, and/or reinforcement should be increased. Increase of those content(s), however, will deteriorate formability. To solve such a problem, the present invention employed uncrystallized unsaturated polyester resin. Here, crystalline unsaturated polyester resin may be used at such a ratio that (crystalline unsaturated polyester resin/uncrystallized unsaturated polyester resin) is 1/3 or less (mass ratio). More preferably, the ratio thereof is (crystalline unsaturated polyester resin/uncrystallized unsaturated polyester resin) ≤ 1/4. As a matter of course, a case where no crystalline unsaturated polyester resin is used is preferred. Even in a case where crystalline unsaturated polyester resin was used, a preferable ratio of (amount of crystalline unsaturated polyester resin/amount of uncrystallized unsaturated polyester resin) was 1/3 or less. In a case where the amount of crystalline unsaturated polyester resin was large, a merit decreased in comparison with a case where uncrystallized unsaturated polyester resin was used. In the present invention, (the diallyl phthalate and/or diallyl isophthalate)/(the uncrystallized unsaturated polyester resin) ≥ 50/50 (mass ratio) is satisfied. More specifically, by increasing the amount of the diallyl phthalate and/or diallyl isophthalate to the amount of the uncrystallized unsaturated polyester resin, a drawback when using the uncrystallized unsaturated polyester resin could be overcome. Also, the merit of using the uncrystallized unsaturated polyester resin could be effectively produced. Preferably, (the diallyl phthalate and/or diallyl isophthalate)/(the uncrystallized unsaturated polyester resin) was 60/40 (mass ratio) or more. Preferably, (the diallyl phthalate and/or diallyl isophthalate)/(the uncrystallized unsaturated polyester resin) was 80/20 (mass ratio) or less. More preferably, the ratio thereof was 70/30 (mass ratio) or less. An amount of the white-based pigment was 80-500 pts.mass to 100 pts.mass of the thermosetting resin. More preferably, the amount thereof was 450 pts.mass or less. When the blending amount of the white-based pigment was as described above, the light reflecting body was, specially, excellent in heat resistance and had a high light reflectance. Preferably, the white-based pigment had an average grain size of 2 µm or smaller. More preferably, the average grain size thereof was 0.1-1 µm. Further preferably, the average grain size thereof was 0.2-0.6 µm. Preferably, the white-based pigment was treated with inorganic powder. Preferably, the inorganic powder was one or two or more selected from the group comprising (including) silica, alminium, and zirconia. Preferably, the white-based pigment was treated with an organic compound.

Preferably, a polymerization initiator is used for constituting the thermosetting resin. Preferably, an amount of the polymerization initiator was 1-10 pts.mass to 100 pts.mass of the thermosetting resin. More preferably, the amount thereof was 1.5 pts.mass or more. Further preferably, the amount thereof was 5 pts.mass or less. Still further preferably, the amount thereof was 3.5 pts.mass or less.

Preferably, the material comprises (includes/contains) an inorganic filler. Preferably, an amount of the inorganic filler was 80-500 pts.mass to 100 pts.mass of the thermosetting resin. Preferably, the inorganic filler was one or two or more selected from the group comprising (including) silica, aluminium hydroxide, aluminum oxide, magnesium oxide, barium sulfate, magnesium carbonate, and barium carbonate.

Preferably, the material comprises (includes/contains) a mold release agent. Preferably, an amount of the mold release agent was 0.25-3.75 pts.mass to 100 pts.mass of the thermosetting resin. More preferably, the amount thereof was 0.75 pts.mass or more. Further preferably, the amount thereof was 2.5 pts.mass or less. Preferably, the material comprises (includes/contains) a reinforcement. Preferably, an amount of the reinforcement was 75 pts.mass or less to 100 pts.mass of the thermosetting resin. More preferably, the amount thereof was 37.5 pts.mass or less. Further preferably, the amount thereof was 20 pts.mass or less. An amount of the reinforcement may be zero. A lower limit of the amount of the reinforcement could be 10 pts.mass. Preferably, the material comprises (contains) a silane coupling agent. Preferably, an amount of the silane coupling agent was 0.25-12.5 pts.mass to 100 pts.mass of the thermosetting resin. More preferably, the amount thereof was 1.25 pts.mass or more. Further preferably, the amount thereof was 7.5 pts.mass or less.

A second invention is directed to a light reflecting body. The reflecting body comprises (includes) also a reflector plate. The light reflecting body is, for example, an LED reflector. The light reflecting body is made of a light reflector material. For example, the light reflecting body is formed via injection molding. Alternatively, the light reflecting body is formed via transfer molding. Further alternatively, the light reflecting body is formed via compression molding. The other molding methods may be used.

A third invention is directed to a lighting device. The lighting device comprises (includes) the light reflecting body.

The lighting device will be further described below in detail.

The uncrystallized unsaturated polyester resin can be obtained via, for example, dehydrating condensation reaction between unsaturated polybasic acid and polyhydric alcohol. Examples of unsaturated polybasic acids include maleic acid, maleic anhydride, fumaric acid, citraconic acid, mesaconic acid, itaconic acid, tetrahydrophthalic acid, tetrahydrophthalic anhydride, methyltetrahydrophthalic anhydride, and glutaconic acid. Examples of polyhydric alcohol (e.g., glycols) include ethylene glycol, 1,3-propanediol, 1,4- butanediol, 1,5-pentanediol, 1,6-hexanediol, propylene glycol, diethylene glycol, triethylene glycol, dipropylene glycol, neopentyl glycol, 1,3- butanediol, hydrogenated bisphenol A, bisphenol A propylene oxide compound, cyclohexane dimethanol, and dibromoneopentyl glycol. The unsaturated polybasic acids and the polyhydric alcohol are used to obtain uncrystallized unsaturated polyester resin via blending adjustment. Whether the obtained unsaturated polyester resin is non-crystalline type or not can be confirmed by confirming if no melting point is found by a thermal analysis device.

An example of the white-based pigment includes titanium oxide. Additionally, examples of the white-based pigment include barium titante, strontium titanate, aluminum oxide, magnesium oxide, zinc oxide, barium sulfate, magnesium carbonate, barium carbonate, and zirconium oxide. One or two or more selected from the above listed substances can be used as required. Among the above listed substances, titanium oxide, aluminum oxide, and barium titante were preferred. The titanium dioxide (TiO₂) was specially preferred. Examples of the titanium dioxide include anatase type titanium oxide, rutile type titanium oxide, and brucite type titanium oxide. Among them, the rutile type titanium oxide was specially preferred because of its excellent thermostability. Preferably, the white-based pigment has an average grain size of 2 µm or smaller. More preferably, the average grain size thereof was 0.1-1 µm. Further preferably, the average grain size thereof was 0.2-0.6 µm. The average grain sizes were measured by a laser diffraction scattering method. Preferably, the titanium oxide powder was subjected to surface treatment by using at least one selected from the group comprising (including) silica, alumina, and zirconia. The titanium oxide has a photocatalyst function. There was a threat that inclusion of titanium oxide in a light reflecting body might cause a damage to the light reflecting body due to a photocatalyst effect of the titanium oxide. Contrary to expectations, if silica, etc., existed on (was attached to) a surface of the titanium oxide powder, regardless of inclusion of titanium oxide in the light reflecting body, the light reflecting body was hardly damaged. The reason thereof was imagined that the photocatalyst effect of titanium oxide was weakened because of the existence of silica, etc., on the surface. The silica, etc., attaches on the surface of the white-based pigment (titanium oxide). Therefore, a preferable size of the silica, etc., is smaller than a size of the white-based pigment (titanium oxide). A size of the silica, etc., is, for example, 1 µm or smaller. As an organic compound to be used in surface treatment of the white-based pigment, for example, silane coupling agent, organic acid, polyol, and silicone are employed. Specially, when the titanium oxide had been subjected to surface treatment by using a fatty acid and a silane coupling agent, coagulation of titanium oxide hardly occurred even when the titanium oxide was a fine particle. As described above, the white-based pigment (titanium oxide) having been subjected to surface treatment with the fatty acid and the silane coupling agent was preferred.

To obtain the thermosetting resin, for example, a polymerization initiator was used in addition to the uncrystallized unsaturated polyester resin, etc. A preferable polymerization initiator was heat decomposable organic peroxide. For example, dicumyl peroxide was preferred. Also, t-butylperoxy-2-ethylhexyl carbonate, 1,1-di(t-hexylperoxy) cyclohexane, 1,1-di(t-butylperoxy)-3,3,5-trimethyl cyclohexane, t-butyl peroxyoctoate, benzoyl peroxide, methyl ethyl ketone peroxide, acetylacetone peroxide, t-butyl peroxybenzoate, 2,5- dimethyl-2,5-di(t-butylperoxy) hexane, etc., are exemplified. Among them, organic peroxide at a 10-hour half-life temperature of 95°C or higher is preferred. Dicumyl peroxide is exemplified. The polymerization initiator may be used alone or in combination with two or more of them. A composition comprising (containing) the above described component(s) is used for polymerization treatment. As a result, the thermosetting resin could be obtained.

As the reinforcement, a glass fiber is exemplified. Alternatively, vinylon fiber, aramid fiber, polyester fiber, and wollastonite are exemplified. Among them, the glass fiber was preferred. Examples of the glass fiber include E-glass (alkali-free glass for electrical use) made of silica glass and/or borosilicate glass, C-glass (alkali glass for chemical use), A-glass (acid-resistant glass), and S-glass (high-strength glass). The above exemplified types of glass are formed into a long fiber (roving) and a short fiber (chopped strands) to be used as required. Surface treatment may be provided to those types of glass fibers. Specially, such a method that an E-glass fiber having a fiber diameter of 10-15 µm is subjected to surface treatment by using a silane coupling agent, and 200, 400, or 800 surface treated-monofilaments are converged by using a sizing agent such as vinyl acetate is employed. When an amount of the reinforcement becomes larger, reflectance degraded. Therefore, it was preferred that the amount of the reinforcement was as small as possible if the light reflecting body could secure a sufficient strength as light reflecting body. In other words, a preferred amount of the reinforcement was 75 pts.mass or less to 100 pts.mass of the thermosetting resin. More preferable amount thereof was 37.5 pts.mass or less. Further preferable amount thereof was 20 pts.mass or less.

An example of the mold release agent includes a wax used for thermosetting resin (e.g., fatty acid wax, fatty acid metal salt wax, and mineral-based wax). The fatty acid wax and the fatty acid metal salt wax were preferred because an LED reflector excellent in heat resistance could be obtained. More specifically, examples of the mold release agent include stearic acid and stearate (e.g., zinc stearate, aluminum stearate, and calcium stearate). The mold release agent may be used alone or in combination of two or more of them. Preferably, an amount of the mold release agent was 0.25-3.75 pts.mass to 100 pts.mass of the thermosetting resin. More preferably, the amount thereof was 0.75 pts.mass or more. Further preferably, the amount thereof was 2.5 pts.mass or less. In a case where a blending amount of the mold release agent was adjusted to the above described amounts, a light reflecting body having superior releasability and good appearance and excellent in light reflectance could be obtained.

Examples of the other additives include a phosphor-containing antioxidant additive and a hindered amine based additive. Examples of the phosphor-containing antioxidant agent include disteallylpentaerythritol diphosphate, and tetrakis(2,4-di-t-butyl-5-methylphenyloxide)-4,4'-biphenylenediphosphine. Examples of the hindered amine based agent include (Bis(2,2,6,6-tetramethyl-4-piperidyl) sebacate), dibutylamine-1,3,5-Triazine-N,N'-Bis(2,2,6,6-tetramethyl-4-piperidyl)butylamine, and tetrakis (1,2,2,6,6-pentamethyl-4-piperidyl)-1,2,3,4-butanetetracarboxylate. A desirable amount thereof to be added is 0.1-10 pts.wt. to 100 pts.wt. of resin.

In addition to the above listed blending components, in order to adjust a curing condition of resin, a proper amount of curing catalyst, a polymerization inhibitor, thickener, other organic additives and inorganic additives, etc., are blended as required.

Each component of the light reflector material (composition) is blended to be mixed uniformly by means of a mixing machine (e.g., mixer and blender). Subsequently, the blended components are kneaded by means of a kneader (e.g., pressurizing kneader, heating roll, and extruder), followed by grinding and regulation of grain size of the kneaded mixture.

A resin composition obtained by the blending is, for example, a dry type resin composition. The dry type means a solidified state under a temperature range of 30°C or lower. The dry type resin composition can be processed to be formed into particles via a grinding process (or a pellet extruding process). The composition was excellent in preservation and handling ability in comparison with the wet type unsaturated polyester resin composition, epoxy resin composition, etc., having viscosity. There was a difficulty for the wet type unsaturated polyester resin composition having the viscosity to be formed into pellets. The wet type unsaturated polyester resin composition was inferior in handling ability. In a case where the wet type unsaturated polyester resin composition is molded by means of an injection molding machine, it was necessary to provide additional equipment such as a plunger on a hopper. This caused increase of cost.

The light reflecting body can be obtained by using the thermosetting resin composition. The resin composition is a dry type composition. The resin composition has a good heat stability upon melting. Therefore, in molding the resin composition, a melting-and-heating molding method (e.g., injection molding method, injection compression molding method, and transfer molding method) can be used. Among them, the injection molding method by using an injection molding machine is especially suitable. The injection molding method can shorten a molding time and manufacture a light reflecting body having a complicated shape with ease. The obtained light reflecting body showed little discoloration by heat. A lighting device with the light reflecting body and an LED had a long lifetime. Such lighting device is inexpensive. Further, a burr generated on a frame of the molded light reflecting body could be removed with ease by, for example, blast processing (and/or machining center processing). For example, shot blasting, sand blasting, and glass beads blasting can be used.

The lighting device comprises (includes) the light reflecting body. FIG. 1 is a schematic cross section view illustrating the LED lighting device. An LED reflector (light reflecting body) 3 is a reflector plate contributing to an effective reflection of emitted light from an LED element 2 mounted on a lead frame 1. A shape thereof can be designed, as required, considering a light quantity, color, directivity, etc., of the LED element 2 to be mounted on the lead frame 1. Preferably, the LED reflector (light reflecting body) 3 has such a shape that the LED reflector 3 encompasses the lead frame 1 when considering an adhesive strength therebetween. In a case where a metal-made lead frame 1 is employed, the lead frame may be subjected to metal surface treatment by using a triazine-based compound in order to enhance the adhesive strength with the LED reflector 3.

Hereinafter, the present invention will be described in detail. The following examples are mere examples of the present invention. The present invention is not limited to the following examples.

### [Light reflector material]

### [Unsaturated Polyester Resin]

A1: uncrystallized unsaturated polyester resin (JAPAN U-PICA Company, Ltd.: 8510)
A3: uncrystallized unsaturated polyester resin (JAPAN U-PICA Company, Ltd.: 8542)
A4: uncrystallized unsaturated polyester resin (JAPAN U-PICA Company, Ltd.: 8524)
A2: crystalline unsaturated polyester resin (Pionear Plastisc Co.: P275)

### [Crosslinking Agent]

B1: diallyl isophthalate prepolymer (DAISO CO., LTD.: ISO DAP)
B3: diallyl isophthalate monomer (DAISO CO., LTD.: MONOMER 100)
B2: diallyl phthalate prepolymer (DAISO CO., LTD.: DAP-A)
B4: diallyl phthalate monomer (DAISO CO., LTD.: DAP-MONOMER)

### [Polymerization Initiator]

C: dicumyl peroxide (NOF CORPORATION: PERCUMYL-D40) [White-Based Pigment]
D: titanium oxide (average grain size of 0.25 µm; ISHIHARA SANGYO KAISHA LTD.: UT-771) surface treatment: Al₂O₃, ZrO₂, organic compound

### [Inorganic Filler]

E: silica

### [Reinforcement]

F: glass fiber

### [Mold Release Agent]

G: calcium stearate

### [Stabilizer]

H: hindered amine-based compound (ADEKA CORPORATION: LA-63P)

**Table-1**

| | A1 | A2 | B1 | B2 | C | D | E | F | G | H |
|---|---|---|---|---|---|---|---|---|---|---|
| Example | 40 | 0 | 0 | 60 | 5 | 200 | 100 | 0 | 2 | 0.5 |
| Example 2 | 40 | 0 | 60 | 0 | 5 | 200 | 100 | 0 | 2 | 0.5 |
| Example 3 | 30 | 0 | 70 | 0 | 5 | 200 | 100 | 0 | 2 | 0.5 |
| Example 4 | 20 | 0 | 80 | 0 | 5 | 200 | 100 | 0 | 2 | 0.5 |
| Example 5 | 40 | 0 | 60 | 0 | 5 | 150 | 150 | 10 | 2 | 0.5 |
| Example 6 | 40 | 0 | 30 | 30 | 5 | 200 | 100 | 0 | 2 | 0.5 |
| Example 7 | 35 | 5 | 60 | 0 | 5 | 200 | 100 | 0 | 2 | 0.5 |
| Example 8 | 40 | 0 | 0 | (B3) 60 | 5 | 200 | 100 | 0 | 2 | 0.5 |
| Example 9 | 40 | 0 | (B4) 60 | 0 | 5 | 200 | 100 | 0 | 2 | 0.5 |
| Example 10 | (A3) 40 | 0 | 60 | 0 | 5 | 200 | 100 | 0 | 2 | 0.5 |
| Example 11 | (A4) 40 | 0 | 60 | 0 | 5 | 200 | 100 | 0 | 2 | 0.5 |
| Comparison Example 1 | 60 | 0 | 0 | 40 | 5 | 300 | 0 | 0 | 2 | 0.5 |
| Comparison Example 2 | 0 | 40 | 0 | 60 | 5 | 100 | 100 | 0 | 2 | 0.5 |
| Comparison Example 3 | 0 | 20 | 0 | 80 | 5 | 100 | 0 | 0 | 2 | 0.5 |

| | | | | | | | | | | |
|---|---|---|---|---|---|---|---|---|---|---|
| *In Example 8, B3 was used instead of B2. *In Example 9, B4 was used instead of B1. *In Example 10, A3 was used instead of A1. *In Example 11, A4 was used instead of A1. | | | | | | | | | | |

The component was kneaded at ratios (pts.mass) of Table-1.

An injection molding machine (manufactured by MATSUDA SEISAKUSHO CO., LTD., 100 t, thermosetting type injection molding machine) was used. In accordance with JISK6911, a disk-shaped test piece was molded (mold temperature of 160°C, curing time of 60 sec.). The test piece was evaluated visually. Formability was evaluated based on its appearance. The formability was shown by good (o) and no good (×). A result thereof is shown in Table-2.

A horizontal expansion meter manufactured by Rigaku Corporation was used for measurement (60°C-180°C) of a coefficient of linear expansion.

A characteristic of light reflecting body (LED reflector) was detected by using the test piece.

Heat Resistant: Whiteness at a temperature of 150°C after 500 hours elapsed was measured by using a thermo-hygrostat (PHP-101 manufactured by ESPEC).

Light Resistant: Whiteness at a temperature of 120°C after irradiating ultraviolet rays having a wavelength of 300 nm or longer for 500 hours was measured by using a light resistance tester (M1TSUWA FRONTECH CORP: Super Win Mini).

A spectral colorimeter (CM-5 manufactured by KONICA MINOLTA HOLDINGS., INC) was used for measurement of whiteness. Based on the obtained L*, a*, and b* values, whiteness (whiteness = {(100-L*)² + a*² + b*²}^{1/2}) was calculated.

A result thereof is shown in Table-2.

**Table-2**

| | Formability | Coefficient of linear expansion | Heat resistance | Light resistance |
|---|---|---|---|---|
| Example 1 | ○ | 37 | -5 | -3 |
| Example 2 | ○ | 36 | -4 | -3 |
| Example 3 | ○ | 33 | -5 | -3 |
| Example 4 | ○ | 30 | -4 | -3 |
| Example 5 | ○ | 32 | -5 | -3 |
| Example 6 | ○ | 35 | -5 | -3 |
| Example 7 | ○ | 40 | -5 | -3 |
| Example 8 | ○ | 37 | -4 | -3 |
| Example 9 | ○ | 36 | -5 | -3 |
| Example 10 | ○ | 36 | -5 | -3 |
| Example 11 | ○ | 37 | -5 | -3 |
| Comparison example 1 | × | 40 | -8 | -5 |
| Comparison example 2 | Δ | 60 | -8 | -6 |
| Comparison example 3 | ○ | 70 | -9 | -6 |

| | | | | |
|---|---|---|---|---|
| *Value of whiteness in column of heat resistance (light resistance) = {(whiteness after the test of heat resistance (light resistance)) - (whiteness before starting (in the early stage) the test} | | | | |

From Table-2, it is learned that the material of the present invention is excellent in heat resistance and light resistance. It is also known that the material has good formability. It is further known that distortion hardly occurs in the material. In other words, the material has high dimensional accuracy.

In Comparison Example 1 (the material having a large ratio of uncrystallized unsaturated polyester resin), heat resistance and light resistance are poor. Further, the material has inferior formability.

In Comparison Example 2 (crystalline unsaturated polyester resin was used), heat resistance and light resistance are poor. Further, the material has inferior formability. Still further, distortion likely occurs in the material. In other words, the material has inferior dimensional accuracy.

In Comparison Example 3 (crystalline unsaturated polyester resin was used; a small ratio of crystalline unsaturated polyester resin (a large ratio of diallyl phthalate)), heat resistance and light resistance are poor. Further, distortion likely occurs in the material. In other words, the material has inferior dimensional accuracy.

Even in a case where a ratio of diallyl phthalate (or diallyl isophthalate) is large, if (amount of uncrystallized unsaturated polyester resin/amount of crystalline unsaturated polyester resin) ≤ 1 (mass ratio) is satisfied (a case of little uncrystallized unsaturated polyester resin), heat resistance and light resistance were poor.

### [REFERENCE CHARACTER LIST]

- 1: lead frame
- 2: LED ELEMENT
- 3: LED reflector (light reflecting body)

## Claims

1. A light reflector material:
wherein the material comprises at least thermosetting resin and a white-based pigment;
wherein the white-based pigment is at least one selected from the group consisting of titanium oxide, barium titanate, strontium titanate, aluminum oxide, magnesium oxide, zinc oxide, barium sulfate, magnesium carbonate, barium carbonate, and zirconium oxide;
wherein an amount of the white-based pigment is 80-500 pts.mass to 100 pts.mass of the thermosetting resin;
wherein the thermosetting resin is comprised by using at least uncrystallized unsaturated polyester resin and diallyl phthalate and/or diallyl isophthalate;
and
wherein 50/50 (mass ratio) ≤ (the diallyl phthalate and/or diallyl isophthalate)/(the uncrystallized unsaturated polyester resin) is satisfied.

2. The light reflector material according to claim 1, wherein (the diallyl phthalate and/or diallyl isophthalate)/(the uncrystallized unsaturated polyester resin) ≤ 80/20 (mass ratio) is satisfied.

3. The light reflector material according to claim 1 or claim 2, wherein 60/40 (mass ratio) ≤ (the diallyl phthalate and/or diallyl isophthalate)/(the uncrystallized unsaturated polyester resin) ≤ 70/30 (mass ratio) is satisfied.

4. The light reflector material according to any one of claim 1 to claim 3, wherein the white-based pigment is titanium oxide-based powder.

5. The light reflector material according to any one of claim 1 to claim 4, wherein the white-based pigment is treated with inorganic powder.

6. The light reflector material according to claim 5, wherein the inorganic powder is one or two or more selected from the group comprising silica, alumina, and zirconia.

7. The light reflector material according to any one of claim 1 to claim 5, wherein the white-based pigment is treated with an organic compound.

8. The light reflector material according to any one of claim 1 to claim 7, wherein the thermosetting resin is comprised by using a polymerization initiator.

9. The light reflector material according to claim 8, wherein an amount of the polymerization initiator is 1-10 pts.mass to 100 pts.mass of the thermosetting resin.

10. The light reflector material according to any one of claim 1 to claim 9, wherein the material comprises an inorganic filler.

11. The light reflector material according to claim 10, wherein an amount of the inorganic filler is 80-500 pts.mass to 100 pts.mass of the thermosetting resin.

12. The light reflector material according to any one of claim 1 to claim 11, wherein 0 ≤ (crystalline unsaturated polyester resin/the uncrystallized unsaturated polyester resin) ≤ 1/3 (mass ratio) is satisfied.

13. A light reflecting body made of the light reflector material according to any one of claim 1 to claim 12.

14. A lighting device with a light reflecting body made of the light reflector material according to any one of claim 1 to claim 12.

## Patentansprüche

1. Ein Lichtreflektor-Material:
wobei das Material mindestens ein duroplastisches Harz und ein Weißpigment umfasst;
wobei das Weißpigment mindestens eines, ausgewählt aus der Gruppe bestehend aus Titanoxid, Bariumtitanat, Strontiumtitanat, Aluminiumoxid, Magnesiumoxid, Zinkoxid, Bariumsulfat, Magnesiumcarbonat, Bariumcarbonat und Zirkoniumoxid ist;
wobei eine Menge des Weißpigments 80-500 Massenteile, bezogen auf 100 Massenteile des duroplastischen Harzes beträgt;
wobei das duroplastische Harz durch Verwendung von mindestens nicht kristallisiertem ungesättigtem Polyesterharz und Diallylphthalat und/oder Diallylisophthalat umfasst ist; und
wobei 50/50 (Massenverhältnis) ≤ (das Diallylphthalat und/oder Diallylisophthalat)/(das nicht kristallisierte ungesättigte Polyesterharz) erfüllt ist.

2. Das Lichtreflektor-Material gemäß Anspruch 1, wobei (das Diallylphthalat und/oder Diallylisophthalat)/(das nicht kristallisierte ungesättigte Polyesterharz) ≤ 80/20 (Massenverhältnis) erfüllt ist.

3. Das Lichtreflektor-Material gemäß Anspruch 1 oder Anspruch 2, wobei 60/40 (Massenverhältnis) ≤ (das Diallylphthalat und/oder Diallylisophthalat)/(das nicht kristallisierte ungesättigte Polyesterharz) ≤ 70/30 (Massenverhältnis) erfüllt ist.

4. Das Lichtreflektor-Material gemäß einem von Anspruch 1 bis Anspruch 3, wobei das Weißpigment ein Pulver auf Titanoxidbasis ist.

5. Das Lichtreflektor-Material gemäß einem von Anspruch 1 bis Anspruch 4, wobei das Weißpigment mit anorganischem Pulver behandelt ist.

6. Das Lichtreflektor-Material gemäß Anspruch 5, wobei das anorganische Pulver eines oder zwei oder mehrere, ausgewählt aus der Gruppe bestehend aus Siliziumdioxid, Aluminiumoxid und Zirkondioxid ist.

7. Das Lichtreflektor-Material gemäß einem von Anspruch 1 bis Anspruch 5, wobei das Weißpigment mit einer organischen Verbindung behandelt ist.

8. Das Lichtreflektor-Material gemäß einem von Anspruch 1 bis Anspruch 7, wobei das duroplastische Harz durch Verwendung eines Polymerisationsinitiators umfasst ist.

9. Das Lichtreflektor-Material gemäß Anspruch 8, wobei eine Menge des Polymerisationsinitiators 1-10 Massenteile, bezogen auf 100 Massenteile des duroplastischen Harzes, beträgt.

10. Das Lichtreflektor-Material gemäß einem von Anspruch 1 bis Anspruch 9, wobei das Material einen anorganischen Füllstoff umfasst.

11. Das Lichtreflektor-Material gemäß Anspruch 10, wobei eine Menge des anorganischen Füllstoffs 80-500 Massenteile, bezogen auf 100 Massenteile des duroplastischen Harzes, beträgt.

12. Das Lichtreflektor-Material gemäß einem von Anspruch 1 bis Anspruch 11, wobei 0 ≤ (kristallisiertes ungesättigtes Polyesterharz/des nicht kristallisierten ungesättigten Polyesterharzes) ≤ 1/3 (Massenverhältnis) erfüllt ist.

13. Ein lichtreflektierender Körper, hergestellt aus dem Lichtreflektor-Material gemäß einem von Anspruch 1 bis Anspruch 12.

14. Eine Beleuchtungsvorrichtung mit einem lichtreflektierenden Körper, hergestellt aus dem Lichtreflektor-Material gemäß einem von Anspruch 1 bis Anspruch 12.

## Revendications

1. Matériau réfléchissant la lumière,
ledit matériau comprenant au moins une résine thermodurcissable et un pigment à base de blanc ;
dans lequel le pigment à base de blanc est au moins l'un choisi dans le groupe constitué par l'oxyde de titane, le titanate de baryum, le titanate de strontium, l'oxyde d'aluminium, l'oxyde de magnésium, l'oxyde de zinc, le sulfate de baryum, le carbonate de magnésium, le carbonate de baryum, et l'oxyde de zirconium ; dans lequel la quantité du pigment à base de blanc est de 80 à 500 parties en masse pour 100 parties en masse de la résine thermodurcissable ;
dans lequel la résine thermodurcissable est obtenue par utilisation d'au moins une résine de polyester insaturé non cristallisée et de phtalate de diallyle et/ou d'isophtalate de diallyle ;
et
dans lequel l'inégalité 50/50 (rapport en masse) ≤ (le phtalate de diallyle et/ou l'isophtalate de diallyle) / (la résine de polyester insaturé non cristallisée) est satisfaite.

2. Matériau réfléchissant la lumière selon la revendication 1, dans lequel l'inégalité (le phtalate de diallyle et/ou l'isophtalate de diallyle) / (la résine de polyester insaturé non cristallisée) ≤ 80/20 (rapport en masse) est satisfaite.

3. Matériau réfléchissant la lumière selon la revendication 1 ou la revendication 2, dans lequel l'inégalité 60/40 (rapport en masse) ≤ (le phtalate de diallyle et/ou l'isophtalate de diallyle) / (la résine de polyester insaturé non cristallisée) ≤ 70/30 (rapport en masse) est satisfaite.

4. Matériau réfléchissant la lumière selon l'une quelconque des revendications 1 à 3, dans lequel le pigment à base de blanc est une poudre à base d'oxyde de titane.

5. Matériau réfléchissant la lumière selon l'une quelconque des revendications 1 à 4, dans lequel le pigment à base de blanc est traité avec une poudre inorganique.

6. Matériau réfléchissant la lumière selon la revendication 5, dans lequel la poudre inorganique est une ou deux ou plus de deux choisies dans le groupe comprenant la silice, l'alumine et la zircone.

7. Matériau réfléchissant la lumière selon l'une quelconque des revendications 1 à 5, dans lequel le pigment à base de blanc est traité avec un composé organique.

8. Matériau réfléchissant la lumière selon l'une quelconque des revendications 1 à 7, dans lequel la résine thermodurcissable est obtenue par utilisation d'un amorceur de polymérisation.

9. Matériau réfléchissant la lumière selon la revendication 8, dans lequel la quantité de l'amorceur de polymérisation est de 1 à 10 parties en masse pour 100 parties en masse de la résine thermodurcissable.

10. Matériau réfléchissant la lumière selon l'une quelconque des revendications 1 à 9, ledit matériau comprenant une charge inorganique.

11. Matériau réfléchissant la lumière selon la revendication 10, dans lequel la quantité de la charge inorganique est de 80 à 500 parties en masse pour 100 parties en masse de la résine thermodurcissable.

12. Matériau réfléchissant la lumière selon l'une quelconque des revendications 1 à 11, dans lequel l'inégalité 0 ≤ (résine de polyester insaturé cristalline / résine de polyester insaturé non cristallisée) ≤ 1/3 (rapport en masse) est satisfaite.

13. Corps réfléchissant la lumière fait du matériau réfléchissant la lumière selon l'une quelconque des revendications 1 à 12.

14. Dispositif d'éclairage doté d'un corps réfléchissant la lumière fait du matériau réfléchissant la lumière selon l'une quelconque des revendications 1 à 12.
